# EUROPÄISCHE PATENTANMELDUNG

(11) **EP 4 096 377 A1**
(43) Veröffentlichungstag der Anmeldung: **30.11.2022**
(21) Anmeldenummer: 21176257.0
(22) Anmeldetag: 27.05.2021
(51) Int. Cl.: H05K 7/20

(54) **SCHALTSCHRANK FÜR LEISTUNGSELEKTRONIK**

(71) Anmelder: Siemens Aktiengesellschaft, 80333 München (DE)
(72) Erfinder: Danov, Vladimir, 91056 Erlangen (DE); Fleisch, Karl, 91054 Erlangen (DE); Kautz, Martin, 91056 Erlangen (DE); Müller, Volker, 90408 Nürnberg (DE); Rothe, Falk, 91334 Hemhofen (DE); Wohlfart, Manfred, 91369 Wiesenthau (DE)

(57) **Zusammenfassung**

Es wird ein Schaltschrank (1) für Leistungselektronik (2), umfassend eine Kühlvorrichtung (4) zur Kühlung der Leistungselektronik und einen Wärmeübertrager (42) vorgeschlagen, wobei die Kühlvorrichtung (4) einen Hauptkühlkreislauf und einen Nebenkühlkreislauf für ein Kühlmedium aufweist und der Wärmeübertrager (42) innerhalb des Nebenkühlkreislaufes angeordnet ist. Der Schaltschrank (1) ist dadurch gekennzeichnet, dass der Wärmeübertrager (42) an einer Rückwand (40) und/oder zwischen Holmen (41) des Schaltschrankes (1) angeordnet ist.

Weiterhin betrifft die Erfindung ein Verfahren zur Herstellung eines Schaltschrankes (1).

## Beschreibung

Die Erfindung betrifft einen Schaltschrank gemäß dem Oberbegriff des Patentanspruches 1 sowie ein Verfahren zur Herstellung eines Schaltschrankes gemäß dem Oberbegriff des Patentanspruches 15.

Typischerweise werden Schaltschränke als Installationsort für elektrische Komponenten verwendet. Dadurch sind die Komponenten vor Umwelteinflüssen geschützt und zudem kann durch diese ein definierter Personenschutz sichergestellt werden. Beispielsweise umfassen Schaltschränke als Komponenten Informationstechnik, Steuerungen, Leistungselektronik, insbesondere Stromrichtertechnik und/oder Umrichtertechnik, Schalter, Schütze und/oder Sicherungen sowie deren Kombinationen.

Während des Betriebes erwärmen sich Bauteile/Komponenten innerhalb des Schaltschrankes. Somit ist eine aktive Kühlung erforderlich. Hieraus ergeben sich zwei grundsätzliche Anforderungen. Erstens sollen Schaltschränke immer kompakter sein. Zweitens steigt jedoch die Abwärme, die abgeführt werden muss, aufgrund von steigenden Kapazitäten und Leistungen an. Somit ist eine effiziente und integrierte Kühlung von Schaltschränken, insbesondere für Leistungselektronik, auf möglichst kompakten Bauraum anzustreben. Insbesondere kann bei nicht überdimensionierter Kühlung nicht ohne weiteres zusätzliche Wärmelast aufgrund neuer Funktionen aus dem Schaltschrank abgeführt werden. Hierzu wäre eine vollständige Neuauslegung der bestehenden Kühlung erforderlich.

Der vorliegenden Erfindung liegt die Aufgabe zugrunde, einen Schaltschrank mit einer verbesserten Kühlung bereitzustellen.

Die Aufgabe wird durch einen Schaltschrank mit den Merkmalen des unabhängigen Patentanspruches 1 sowie durch ein Verfahren mit den Merkmalen des unabhängigen Patentanspruches 15 gelöst. In den abhängigen Patentansprüchen sind vorteilhafte Ausgestaltungen und Weiterbildungen der Erfindung angegeben.

Der erfindungsgemäße Schaltschrank für Leistungselektronik umfasst eine Kühlvorrichtung zur Kühlung der Leistungselektronik und einen Wärmeübertrager, wobei die Kühlvorrichtung einen Hauptkühlkreislauf und einen Nebenkühlkreislauf für ein Kühlmedium aufweist und der Wärmeübertrager innerhalb des Nebenkühlkreislaufes angeordnet ist. Der erfindungsgemäße Schaltschrank ist dadurch gekennzeichnet, dass der Wärmeübertrager an einer Rückwand und/oder zwischen Holmen des Schaltschrankes angeordnet ist.

Der Schaltschrank weist somit zwei Kühlkreisläufe auf. Der erste Kühlkreislauf (Hauptkühlkreislauf) entspricht beispielsweise der bekannten und/oder bereits in einem Schaltschrank bestehenden Kühlung. Der erfindungsgemäße zusätzliche Wärmeübertrager ist im zweiten Kühlkreislauf, das heißt in den Nebenkühlkreislauf, der somit bezüglich des Hauptkreislaufes einen parallelen Bypass ausbildet, integriert. Dadurch kann der Wärmeübertrager in bereits bestehende Schaltschränke, die eine Kühlvorrichtung aufweisen, gemäß der vorliegenden Erfindung integriert und innerhalb des bereits bestehenden Schaltschrankes angeordnet werden. Vorteilhafterweise wird dadurch das bereits bestehende Kühlkonzept des ursprünglichen Schaltschrankes nicht wesentlich beeinträchtigt. Der Nebenkühlkreislauf ist hierbei bevorzugt derart ausgestaltet, dass dieser keine bis nur sehr geringe Auswirkungen auf den Hauptkühlkreislauf aufweist. Hierbei kann der Druckverlust über den Nebenkühlkreislauf grundsätzlich an den Hauptkühlkreislauf, beispielsweise mittels Blenden, eingestellt und/oder angepasst werden.

Weiterhin ist erfindungsgemäß der Wärmeübertrager, der bezüglich eines bereits bestehenden Schaltschrankes ein zusätzlicher Wärmeübertrager ist, an der Rückwand des Schaltschrankes und/oder zwischen seinen Holmen angeordnet. Dadurch ist kein zusätzlicher Bauraum für den Wärmeübertrager erforderlich.

Mit anderen Worten weisen bereits bekannte Schaltschränke typischerweise an ihrer Rückwand und/oder zwischen ihren Holmen einen Bauraum auf, der für den Wärmeübertrager des Nebenkühlkreislaufes verwendet wird. Dadurch ist keine komplette Neuauslegung des Schaltschrankes beziehungsweise seiner Kühlung bei zusätzlichen Lasten erforderlich. Der Wärmeübertrager kann technisch in den Bauraum an der Rückwand und/oder zwischen den Holmen angeordnet werden. Durch die erfindungsgemäße Anordnung des Wärmeübertragers an der Rückwand und/oder zwischen den Holmen des Schaltschrankes wird vorteilhafterweise bisher nicht verwendeter Bauraum verwendet. Zusätzlicher Bauraum ist somit nicht erforderlich, kann jedoch vorgesehen sein.

Durch den Wärmeübertrager beziehungsweise zusätzlichen Wärmeübertrager (wenn die Kühlvorrichtung bereits einen Wärmeübertrager umfasst) wird die Schaltschranklufttemperatur (Innenraumtemperatur) verringert, wodurch eine verbesserte Kühlung, insbesondere von Nebenaggregaten, erreicht wird. Dadurch verlängert sich deren Lebensdauer.

Weiterhin können die Konstruktion, Auslegung und Aufteilung eines bestehenden Schaltschrankes, beispielsweise eines rein luftgekühlten Schaltschranks, auf ein flüssigkeitsgekühltes System übertragen werden, ohne dass Bauraum für weitere beziehungsweise zusätzliche Komponenten vorgehalten werden muss. In diesem Fall ist das Kühlmedium bevorzugt eine Flüssigkeit, insbesondere Wasser.

Das erfindungsgemäße Verfahren zur Herstellung eines Schaltschranks für Leistungselektronik, umfassend eine Kühlvorrichtung zur Kühlung der Leistungselektronik und einen Wärmeübertrager, wobei die Kühlvorrichtung einen Hauptkühlkreislauf und einen Nebenkühlkreislauf für ein Kühlmedium aufweist und der Wärmeübertrager innerhalb des Nebenkühlkreislaufes angeordnet ist, ist gekennzeichnet dadurch, dass der Wärmeübertrager an einer Rückwand und/oder zwischen Holmen des Schaltschrankes angeordnet wird.

Insbesondere kann der erfindungsgemäße Schaltschrank aus bereits bestehenden Schaltschränken, die eine Kühlvorrichtung aufweisen, insbesondere eine Flüssigkeitskühlung, hergestellt werden. Mit anderen Worten können durch das erfindungsgemäße Verfahren bestehende Schaltschränke zu einem erfindungsgemäßen Schaltschrank erweitert werden.

Es ergeben sich zum erfindungsgemäßen Schaltschrank gleichartige und gleichwertige Vorteile und/oder Ausgestaltungen des erfindungsgemäßen Verfahrens.

Gemäß einer vorteilhaften Ausgestaltung der Erfindung ist der Wärmeübertrager als Rückkühler ausgebildet.

Dadurch kann vorteilhafterweise weitere Abwärme abgeführt werden.

In einer vorteilhaften Weiterbildung der Erfindung umfasst der Wärmeübertrager ein oder mehrere Rippenrohre. Besonders bevorzugt ist der Wärmeübertrager als Rippenrohr, das heißt als beripptes Rohr ausgebildet.

Dadurch wird die Kühlung der Schaltschrankluft beziehungsweise seiner umfassten Komponenten weiter verbessert. Insbesondere werden die Rippenrohre hierbei vom Kühlmedium des Nebenkühlkreislaufes durchströmt. Vorteilhafterweise weisen Rippenrohre typischerweise einen geringen Druckverlust für einen Luftstrom innerhalb des Schaltschrankes auf. Dadurch wird eine bereits innerhalb des Schaltschrankes bestehende und gegebenenfalls vorgesehene Luftströmung verwendet und zugleich so wenig wie möglich beeinflusst (zusätzliche passive Kühlung). Zusätzlich kann ein Lüfter für eine gezielte Strömungsführung zu und/oder weg vom Wärmeübertrager und somit von den Rippenrohren vorgesehen sein. Hierbei wird die erwärmte Schaltschrankluft durch den räumlichen Bereich des Wärmeübertragers hindurchgeleitet (zusätzliche aktive Kühlung). Mit anderen Worten kann der Schaltschrank durch den Wärmeübertrager eine zusätzliche aktive und/oder passive Luftkühlung aufweisen. Weiterhin sind Rippenrohre kostengünstig. Kostenintensive Strangguss-Kühlkörper sind somit nicht erforderlich, können jedoch vorgesehen sein. Weiterhin könnte der Wärmeübertrager additiv gefertigt sein, insbesondere mittels eines 3D Druckverfahrens.

Gemäß einer bevorzugten Ausgestaltung der Erfindung umfasst der Wärmeübertrager ein oder mehrere kissenartig ausgebildete Plattenwärmeübertrager.

Besonders bevorzugt ist der Wärmeübertrager als kissenartiger Plattenwärmeübertrager ausgebildet. Dadurch weist der Wärmeübertrager sinnbildlich mehrere aufgeblasene Kissen auf, die vom Kühlmedium durchströmt werden. Vorteilhafterweise sind solche kissenartigen Plattenwärmeübertrager vergleichsweise flach, sodass diese besonders vorteilhaft an der Rückwand und/oder zwischen den Holmen des Schaltschrankes angeordnet werden können. Die kissenartigen Plattenwärmeübertrager werden ebenfalls als Thermoblech oder Pillow-Plate bezeichnet. Mit anderen Worten ist der Wärmeübertrager bevorzugt als Thermoblech und/oder Pillow-Platte ausgebildet.

In einer vorteilhaften Weiterbildung der Erfindung ist an der Rückseite des Schaltschrankes eine Aufbauwand angeordnet, wobei die Aufbauwand den Wärmeübertrager umfasst.

Mit anderen Worten ist die Rückwand des Schaltschrankes als Aufbauwand ausgebildet oder diese umfasst eine solche Aufbauwand. Durch die Aufbauwand wird die Montage des Wärmeübertragers, die Steuerung des Luftstromes und/oder der Einbau weiterer Komponenten verbessert. Mit anderen Worten dient die Aufbauwand als Montagefläche für elektrische, insbesondere elektronische, und/oder mechanische Komponenten, die beispielsweise funktionsbedingt innerhalb des Schaltschrankes erforderlich sind.

Gemäß einer vorteilhaften Ausgestaltung der Erfindung umfasst die Aufbauwand ein oder mehrere Strömungsbleche zur Strömungsleitung von Luft innerhalb des Schaltschrankes.

Dadurch kann vorteilhafterweise die Strömung der Luft innerhalb des Schaltschrankes und besonders bevorzugt in der Umgebung des Wärmeübertragers eingestellt und gesteuert werden. Mit anderen Worten ermöglichen die Strömungsbleche eine Luftführung. Weiterhin dienen sie für den elektrischen Bauraum als Schutz vor Spritzwasser und/oder Flüssigkeiten. Hierzu sind die Strömungsbleche insbesondere zwischen dem elektrischen Bauraum und dem Wärmeübertrager angeordnet.

In einer vorteilhaften Ausgestaltung der Erfindung umfasst die Aufbauwand ein oder mehrere Schutzbleche zum Schutz der Leistungselektronik, wobei die Schutzbleche der Leistungselektronik zugewandt und zwischen der Leistungselektronik und dem Wärmeübertrager angeordnet sind.

Die Strömungsbleche können als Schutzbleche ausgebildet sein. Weiterhin können die Schutzbleche ebenso der Führung des Luftstromes dienen. Durch die Schutzbleche, die an der Aufbauwand angeordnet und/oder durch diese umfasst sind, schützen die Leistungselektronik zusätzlich. Dadurch wird die Betriebssicherheit, insbesondere im Hinblick darauf, wenn der Wärmeübertrager an der Rückwand und/oder zwischen den Holmen nachträglich installiert wird, erhöht.

Gemäß einer vorteilhaften Ausgestaltung der Erfindung umfasst die Aufbauwand eine Montagefläche für elektronische und/oder mechanische Komponenten des Schaltschrankes.

Vorteilhafterweise kann dadurch die Aufbauwand als Montagewand für die genannten Komponenten verwendet werden. Dadurch wird vorteilhafterweise eine zusätzliche Montagewand ausgebildet. Weiterhin können die angeordneten, das heißt montierten Bauelemente, aufgrund ihrer Nähe zum Wärmeübertrager verbessert gekühlt werden. Zudem kann der Schaltschrank kompakter ausgestaltet werden.

In einer vorteilhaften Weiterbildung der Erfindung ist die Abzweigung des Nebenkühlkreislaufes vom Hauptkühlkreislauf in einem unteren Bereich des Schaltschrankes angeordnet.

Das ist deshalb von Vorteil, da Leitungen für den Hauptkühlkreislauf typischerweise in einem unteren Teil des Schaltschrankes angeordnet sind. Weiterhin werden durch die Anordnung der Abzweigung in den unteren Bereich des Schaltschrankes Leckagen in der Nähe der stromführenden Bauteile/Komponenten vermieden. Die Leitungen des Hauptkühlkreislaufes und Nebenkühlkreislaufes erstrecken sich typischerweise als ansonsten flüssigkeitsdichtes Rohr durch den Schaltschrank.

Bevorzugt ist die fluidische Verbindung zwischen dem Hauptkühlkreislauf und dem Nebenkühlkreislauf zerstörungsfrei lösbar ausgebildet.

Beispielsweise wird die fluidische Verbindung durch ein T-Stück ausgebildet. Durch die zerstörungsfrei lösbare Verbindung können wiederum bestehende Schaltschränke durch das Vorsehen eines Nebenkühlkreislaufes und das Anordnen eines in diesem integrierten Wärmeübertragers an der Rückwand und/oder zwischen den Holmen des Schaltschrankes zu einem erfindungsgemäßen Schaltschrank erweitert werden.

Bevorzugt umfasst der Nebenkühlkreislauf Steuerelemente zum Einstellen des Volumenstromes innerhalb des Nebenkühlkreislaufes.

Dadurch kann vorteilhafterweise sichergestellt werden, dass der Volumenstrom und/oder Massenstrom über den Nebenkühlkreislauf nicht zu groß ist. Die Steuerelemente können als Blenden ausgebildet sein.

Gemäß einer vorteilhaften Ausgestaltung der Erfindung ist der Wärmeübertrager innerhalb eines rechteckförmigen Bauraums zwischen den Holmen angeordnet, wobei der Bauraum zwischen den Holmen ein Verhältnis von Tiefe zu Länge von höchstens 0,1 aufweist.

Weiterhin ist der Wärmeübertrager bevorzugt innerhalb eines Bauraums der Rückwand angeordnet, wobei der Bauraum der Rückwand ein Verhältnis von Tiefe zu Länge von höchstens 0,05 aufweist.

Besonders bevorzugt weist der Wärmeübertrager die genannten Verhältnisse auf. Dadurch ist dieser besonders flach ausgebildet und möglichst optimal auf den verfügbaren Bauraum an der Rückwand und/oder den Bauraum zwischen den Holmen angepasst.

In einer vorteilhaften Weiterbildung der Erfindung weist der Wärmeübertrager eine Länge von höchstens 1000mm, eine Breite von höchstens 290mm sowie eine Tiefe von höchstens 20mm auf.

Vorteilhafterweise ist der Wärmeübertrager dadurch an die typischen Größen von freien Bauräumen an der Rückwand und/oder zwischen den Holmen des Schaltschrankes angepasst.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: einen Schaltschrank gemäß einer ersten Ausgestaltung der Erfindung; und
- Figur 2: einen Schaltschrank gemäß einer zweiten Ausgestaltung der Erfindung.

Gleichartige, gleichwertige oder gleichwirkende Elemente können in einer der Figuren oder in den Figuren mit denselben Bezugszeichen versehen sein.

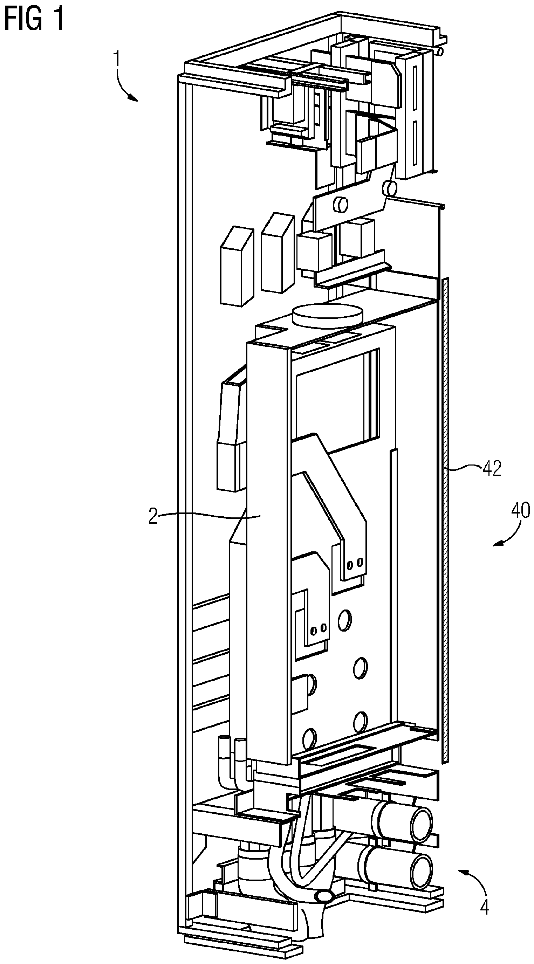

Die Figur 1 zeigt einen Schaltschrank 1 in einer dreidimensionalen Darstellung.

Der Schaltschrank 1 umfasst eine Kühlvorrichtung 4. Die Kühlvorrichtung 4 ist in einem unteren Bereich, das heißt in der Nähe des Bodens des Schaltschrankes 1 angeordnet. Mit anderen Worten sind die stromführenden Komponenten/Bauelemente des Schaltschrankes oberhalb der Kühlvorrichtung 4 angeordnet, sodass bei Leckagen der dargestellten Rohre/Leitungen diese nicht betroffen sind. Die Kühlvorrichtung 4 umfasst typischerweise weitere Kühlkomponenten. In der Figur 1 ist die Kühlvorrichtung 4 durch die zwei dargestellten Rohre symbolisiert, die für eine Zuleitung und Ableitung eines Kühlmediums, insbesondere Wasser, vorgesehen sind.

Weiterhin ist in der Figur 1 ein schraffierter Bereich 42 dargestellt, der einen Bauraum zwischen den Holmen des Schaltschrankes 1 und an einer Rückwand 40 des Schaltschrankes 1 kennzeichnet. Ein Wärmeübertrager, insbesondere ein Rippenrohr, ist innerhalb des Bereiches 42 angeordnet. Somit ist der Wärmeübertrager ebenfalls mit dem Bezugszeichen 42 gekennzeichnet.

Der Wärmeübertrager 42 ist somit in einem Bauraum des Schaltschrankes 1 angeordnet, der bei bekannten Schaltschränken ungenutzt ist. Weiterhin wird der Wärmeübertrager 42 durch einen Nebenkühlkreislauf an den Hauptkühlkreislauf (symbolisiert durch die Rohre im unteren Bereich) angeschlossen und somit mit Kühlmedium, insbesondere Wasser versorgt. Der Anschluss, das heißt die fluidische Verbindung zwischen dem Nebenkühlkreislauf und dem Hauptkühlkreislauf kann mittels eines T-Stücks erfolgen.

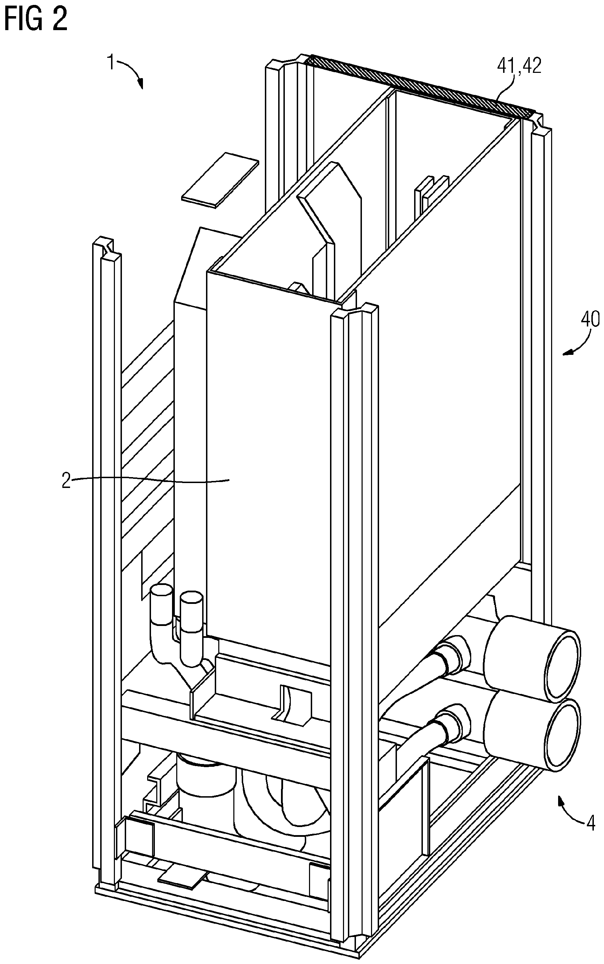

Die Figur 2 zeigt eine schematische dreidimensionale Darstellung eines Schaltschrankes 1 gemäß einer zweiten Ausgestaltung der Erfindung.

Hierbei besteht der Unterschied zur Figur 1 darin, dass der Wärmeübertrager 42 in einem oberen Bereich zwischen den Holmen des Schaltschrankes 1 angeordnet ist. In Figur 1 ist er an der Rückwand und seitlich zwischen den Holmen angeordnet. Somit gilt das unter Figur 1 gesagte ebenso für die in der Figur 2 dargestellte zweite Ausgestaltung. Der Wärmeübertrager 42 könnte ebenfalls an der Rückwand 40 angeordnet sein beziehungsweise könnte ein weiterer Wärmeübertrager vorgesehen sein, der an der Rückwand 40 angeordnet ist. Mit anderen Worten umfasst der Schaltschrank 1 bevorzugt zwei Wärmeübertrager, wobei einer der Wärmeübertrager an der Rückwand 40 des Schaltschrankes 1 angeordnet ist und der weitere Wärmeübertrager zwischen den Holmen des Schaltschrankes 1 in dem schraffierten Zwischenbereich 41.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 1: Schaltschrank
- 2: Leistungselektronik
- 4: Kühleinheit
- 40: Rückwand
- 41: Zwischenbereich
- 42: Wärmeübertrager

## Patentansprüche

1. Schaltschrank (1) für Leistungselektronik (2), umfassend eine Kühlvorrichtung (4) zur Kühlung der Leistungselektronik und einen Wärmeübertrager (42), wobei die Kühlvorrichtung (4) einen Hauptkühlkreislauf und einen Nebenkühlkreislauf für ein Kühlmedium aufweist und der Wärmeübertrager (42) innerhalb des Nebenkühlkreislaufes angeordnet ist, **dadurch gekennzeichnet, dass** der Wärmeübertrager (42) an einer Rückwand (40) und/oder zwischen Holmen (41) des Schaltschrankes (1) angeordnet ist.

2. Schaltschrank (1) gemäß Anspruch 1, **dadurch gekennzeichnet, dass** der Wärmeübertrager (42) als Rückkühler ausgebildet ist.

3. Schaltschrank (1) gemäß Anspruch 1 oder 2, **dadurch gekennzeichnet, dass** der Wärmeübertrager (42) ein oder mehrere Rippenrohre umfasst.

4. Schaltschrank (1) gemäß einem der vorhergehenden Ansprüche, **dadurch gekennzeichnet, dass** der Wärmeübertrager (42) ein oder mehrere kissenartig ausgebildete Plattenwärmeübertrager umfasst.

5. Schaltschrank (1) gemäß einem der vorhergehenden Ansprüche, **dadurch gekennzeichnet, dass** an der Rückseite (40) des Schaltschrankes (1) eine Aufbauwand angeordnet ist, wobei die Aufbauwand den Wärmeübertrager (42) umfasst.

6. Schaltschrank (1) gemäß Anspruch 5, **dadurch gekennzeichnet, dass** die Aufbauwand ein oder mehrere Strömungsbleche zur Strömungsleitung von Luft innerhalb des Schaltschrankes (1) umfasst.

7. Schaltschrank (1) gemäß Anspruch 5 oder 6, **dadurch gekennzeichnet, dass** die Aufbauwand ein oder mehrere Schutzbleche zum Schutz der Leistungselektronik (2) umfasst, wobei die Schutzbleche der Leistungselektronik (2) zugewandt und zwischen der Leistungselektronik (2) und dem Wärmeübertrager (42) angeordnet sind.

8. Schaltschrank (1) gemäß einem der Ansprüche 5 bis 7, **dadurch gekennzeichnet, dass** die Aufbauwand eine Montagefläche für elektronische und/oder mechanische Komponenten des Schaltschrankes (1) umfasst.

9. Schaltschrank (1) gemäß einem der vorhergehenden Ansprüche, **dadurch gekennzeichnet, dass** die Abzweigung des Nebenkühlkreislaufes vom Hauptkühlkreislauf in einem unteren Bereich des Schaltschrankes (1) angeordnet ist.

10. Schaltschrank (1) gemäß einem der vorhergehenden Ansprüche, **dadurch gekennzeichnet, dass** die fluidische Verbindung zwischen dem Hauptkühlkreislauf und dem Nebenkühlkreislauf zerstörungsfrei lösbar ausgebildet ist.

11. Schaltschrank (1) gemäß einem der vorhergehenden Ansprüche, **dadurch gekennzeichnet, dass** der Nebenkühlkreislauf Steuerelemente zum Einstellen des Volumenstromes innerhalb des Nebenkühlkreislaufes umfasst.

12. Schaltschrank (1) gemäß einem der vorhergehenden Ansprüche, **dadurch gekennzeichnet, dass** der Wärmeübertrager (42) innerhalb eines rechteckförmigen Bauraums (41) zwischen den Holmen angeordnet ist, wobei der Bauraum zwischen den Holmen ein Verhältnis von Tiefe zu Länge von höchstens 0,1 aufweist.

13. Schaltschrank (1) gemäß einem der vorhergehenden Ansprüche, **dadurch gekennzeichnet, dass** der Wärmeübertrager (42) innerhalb eines Bauraums der Rückwand (40) angeordnet ist, wobei der Bauraum der Rückwand (40) ein Verhältnis von Tiefe zu Länge von höchstens 0,05 aufweist.

14. Schaltschrank gemäß einem der vorhergehenden Ansprüche, **dadurch gekennzeichnet, dass** der Wärmeübertrager (42) eine Länge von höchstens 1000mm, eine Breite von höchstens 290mm sowie eine Tiefe von höchstens 20mm aufweist.

15. Verfahren zur Herstellung eines Schaltschranks (1) für Leistungselektronik (2), umfassend eine Kühlvorrichtung (4) zur Kühlung der Leistungselektronik und einen Wärmeübertrager (42), wobei die Kühlvorrichtung (4) einen Hauptkühlkreislauf und einen Nebenkühlkreislauf für ein Kühlmedium aufweist und der Wärmeübertrager (42) innerhalb des Nebenkühlkreislaufes angeordnet ist, **gekennzeichnet dadurch, dass** der Wärmeübertrager (42) an einer Rückwand (40) und/oder zwischen Holmen (41) des Schaltschrankes (1) angeordnet wird.
